# EUROPEAN PATENT APPLICATION

(11) **EP 2 249 396 A1**
(43) Date of publication of application: **10.11.2010**
(21) Application number: 09709142.5
(22) Date of filing: 06.02.2009
(51) Int. Cl.: H01L 31/042

(54) **SOLAR CELL MODULE**

(30) Priority: 06.02.2008 JP 2008026949
(71) Applicant: SANYO Electric Co., Ltd., Moriguchi-shi Osaka 570-8677 (JP)
(72) Inventor: YAGIURA, Toshio, Moriguchi City Osaka 570-8677 (JP)
(74) Representative: Calderbank, Thomas Roger
(86) International application number: PCT/JP2009/052045
(87) International publication number: WO 2009/099180

(57) **Abstract**

A solar cell module includes an extracting wire member 30 which is connected to the extracting electrode 20, a covering member 40 covering the extracting wire member 30 and a bonding layer 50 bonding these. The extracting wire member 30 is isolated from the bonding layer 50 by the covering member 40.

## Description

### Technical Field

The present invention relates to a solar cell module including multiple solar cells which are electrically connected to each other in series on a single substrate.

### Background Art

There has been heretofore known a solar cell module including multiple solar cells which are electrically connected to each other in series on a single substrate (see JP-A 2007-35695, for example). Such a solar cell module includes an extracting electrode formed on the single substrate and used to extract electric charges generated by the multiple solar cells to the outside. An extracting wire member which collects electric charges from the extracting electrode is connected to the extracting electrode.

The multiple solar cells, the extracting electrode and the extracting wire member are bonded by a bonding layer, and thus the extracting wire member is in direct contact with the bonding layer. In general, copper is used for a base material of the extracting wire member, whereas EVA (Ethylene vinyl acetate) is used for the bonding layer.

Here, a linear expansion coefficient of EVA (3.5×10⁻⁴) is larger than that of copper (1.7×10⁻⁵). Therefore, the extracting wire member undergoes stress from the bonding layer depending on a temperature change in an environment in which the solar cell module is used. The repetition of application of such stress on the extracting wire member accumulates damage in a connection portion between the extracting wire member and the extracting electrode. This accumulation consequently causes a risk of breaking the connection portion and thereby decreasing output of the solar cell module.

The present invention has been made in view of the above circumstances, and has an object to provide a solar cell module capable of reducing stress which an extracting wire member connected to an extracting electrode undergoes from a bonding layer.

### Disclosure of the Invention

A solar cell module according to the present invention includes a substrate having an insulation property, a plurality of solar cells which are formed on the substrate, an extracting electrode which is formed on the substrate and which is for extracting electric charges generated by the plurality of solar cells, an extracting wire member which is connected to the extracting electrode and which is for collecting electric charges from the extracting electrode, a covering member covering the extracting wire member, and a bonding layer bonding the plurality of solar cells, the extracting electrode, the extracting wire member and the covering member between the bonding layer and the substrate. The extracting wire member is isolated from the bonding layer by the covering member

In the solar cell module described above, the extracting wire member is not in direct contact with the bonding layer. This makes it possible to reduce stress which the extracting wire member undergoes from the bonding layer depending on a temperature change in an environment in which the solar cell module is used. As a result, the damage of a connection portion between the extracting electrode and the extracting wire member can be suppressed.

In the feature of the present invention, the covering member may be an adhesive tape which is adhesive on a surface on the extracting wire member side.

In the feature of the present invention, the covering member may cover the extracting electrode, and the extracting electrode may be isolated from the bonding layer by the covering member.

### Brief Description of the Drawings

[Fig. 1] Fig. 1 is a plan view of a solar cell module 100 according to an embodiment of the present invention.
[Fig. 2] Fig. 2 is a cross-sectional view of a solar cell module 100 according to a first embodiment of the present invention.
[Fig. 3] Fig. 3 is a cross-sectional view of a solar cell module 100 according to a second embodiment of the present invention.

### Best Modes for Carrying Out the Invention

Next, embodiments of the present invention will be described below with reference to the drawings. In the following description of the drawings, the same or similar parts will be denoted by the same or similar reference numerals. However, it should be noted that the drawings are schematic and that their dimensional ratios and the like are different from actual ones. Thus, specific dimensions and the like should be determined by referring to the description below. Naturally, there are portions where dimensional relationships and ratios between the drawings are different.

### [First Embodiment]

### (Structure of Solar Cell Module)

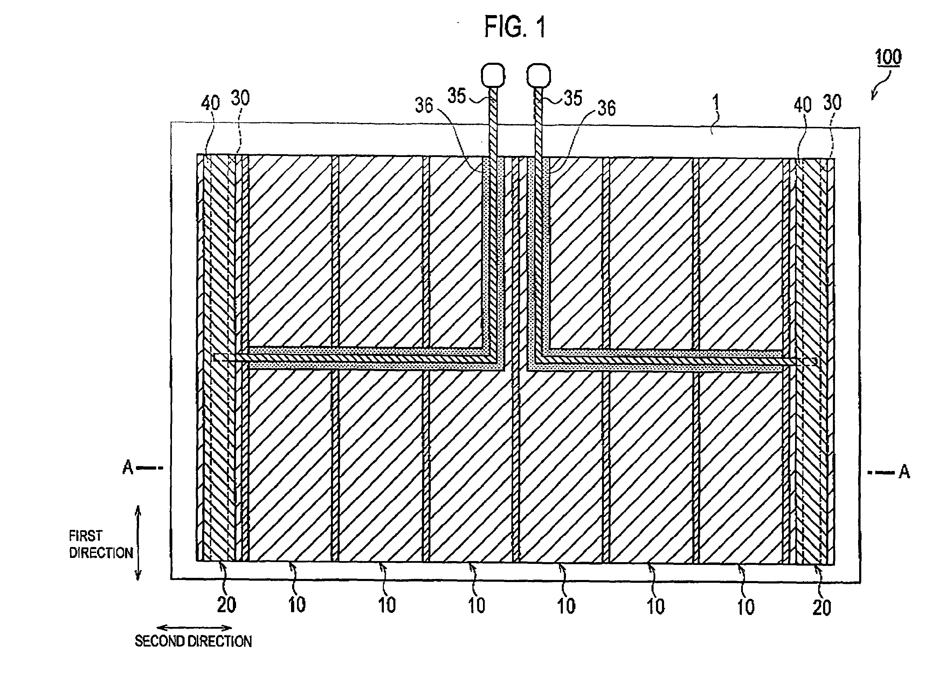

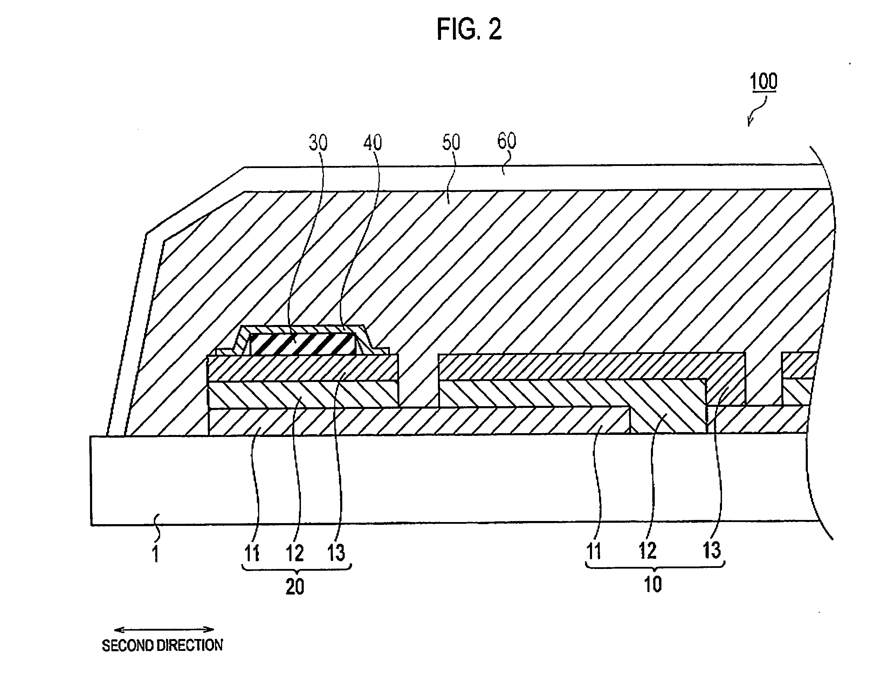

A structure of a solar cell module 100 according to an embodiment of the present invention will be described with reference to Fig. 1 and Fig. 2. Fig. 1 is a plan view showing the rear side of the solar cell module 100. Fig. 2 is an enlarged cross-sectional view taken along the line A-A of Fig. 1.

As shown in Fig. 1 and Fig. 2, the solar cell module 100 includes a substrate 1, multiple solar cells 10, an extracting electrode 20, an extracting wire member 30, an output wire member 35, an insulating film 36, a covering member 40, a bonding layer 50 and a protection member 60. Note that, in Fig. 1, the bonding layer 50 and the protection member 60 are omitted.

The substrate 1 is a single substrate for forming the multiple solar cells 10 and the extracting electrode 20 thereon. Glass, plastic or the like having an insulation property can be used as the substrate 1.

Each of the multiple solar cells 10 is formed in a first direction on the substrate 1. The multiple solar cells 10 are arranged in a second direction substantially orthogonal to the first direction, and are electrically connected to each other in series.

The solar cell 10 includes a first electrode layer 11, a semiconductor layer 12 and a second electrode layer 13. The first electrode layer 11, the semiconductor layer 12 and the second electrode layer 13 are sequentially deposited on the substrate 1, and are patterned by publicly-known laser patterning.

The first electrode layer 11 is deposited on a principal surface of the substrate 1, and is conductive and transparent. As the first electrode layer 11, a metal oxide such as tin oxide (SnO₂), zinc oxide (ZnO), indium oxide (In₂O₃) or titanium oxide (TiO₂) may be used. Incidentally, these metal oxides may be doped with fluorine (F), tin (Sn), aluminum (Al), iron (Fe), gallium (Ga), niobium (Nb) or the like.

The semiconductor layer 12 generates electric charges (electrons and holes) by light incident from the first electrode layer 11 side. As the semiconductor layer 12, for example, a single body or a deposited body of an amorphous silicon semiconductor layer and a microcrystalline silicon semiconductor layer can be used, each layer having a pin-junction structure or a pn-junction structure as a base structure.

As the second electrode layer 13, for example, a single body or a deposited body of ITO, silver (Ag) and the like having conductivity can be used. The second electrode layer 13 of one solar cell 10 is in contact with the first electrode layer 11 of a different solar cell 10 adjacent to the one solar cell 10. Thereby, the one solar cell 10 and the different solar cell 10 are electrically connected to each other in series.

The extracting electrode 20 extracts electric charges from the multiple solar cells 10. The extracting electrode 20 includes the first electrode layer 11, the semiconductor layer 12 and the second electrode layer 13, as similar to the solar cell 10. The first electrode layer 11, the semiconductor layer 12 and the second electrode layer 13 are sequentially deposited on the substrate 1. The extracting electrode 20 is formed in the first direction on the substrate 1.

The extracting wire member 30 extracts electric charges from the extracting electrode 20. In other words, the extracting wire member 30 serves as a collection electrode which collects electric charges from the extracting electrode 20.

The extracting wire member 30 is made of a conductive member. The surface of the extracting wire member 30 may be solder-plated. The extracting wire member 30 is solder-connected to the extracting electrode 20 along the extracting electrode 20 (in the first direction). As the extracting wire member 30, copper or the like molded into a thin-plate shape, a line shape or a twist-line shape maybe used. Note that, the extracting wire member 30 may be solder-connected to the extracting electrode 20 partially at multiple portions. The extracting wire member 30 is covered with the covering member 40 to be described later.

The output wire member 35 leads electric charges collected by the extracting wire member 30 to the outside of the solar cell module 100. The output wire member 35 has the same structure as that of the extracting wire member 30. One end of the output wire member 35 is solder-connected to the extracting wire member 30.

The insulating film 36 is inserted between the solar cell 10 and the output wire member 35. The output wire member 35 is electrically insulated from the solar cell 10 by the insulating film 36.

The covering member 40 is related to a characteristic part of the present invention, and covers the extracting wire member 30 on the extracting electrode 20. Accordingly, as shown in Fig. 2, the covering member 40 is in direct contact with the bonding layer 50 to be described later, but the extracting wire member 30 is not in direct contact with the bonding layer 50. In this manner, the extracting wire member 30 is isolated from the bonding layer 50 by the covering member 40.

Here, the covering member 40 according to this embodiment is an adhesive tape which is adhesive on a surface on the extracting wire member 30 side. The covering member 40 is bonded to the top surface of the extracting wire member 30. Moreover, two edge portions of the covering member 40 are bonded to two edge portions in the first direction of the extracting electrode 20.

The bonding layer 50 bonds the multiple solar cells 10, the extracting electrode 20, the extracting wire member 30 and the covering member 40 between the substrate 1 and the protection member 60. Moreover, the bonding layer 50 cushions impact applied to the solar cell module 100. As the bonding layer 50, a resin of EVA, EEA, PVB, silicon, urethane, acrylic, epoxy or the like can be used.

The protection member 60 is disposed on the bonding layer 50. As the protection member 60, a single body of PET, PEN, ETFE, PVDF, PCTFE, PVF, PC, acrylic, glass, SUS, galvalume or the like, or a deposited body obtained by sandwiching metal foil between these materials, can be used.

### (Method of Manufacturing Solar Cell Module)

First, the first electrode layer 11, the semiconductor layer 12 and the second electrode layer 13 are sequentially deposited on the substrate 1 by using a film-forming method such as a CVD method or a sputtering method. In this event, the first electrode layer 11, the semiconductor layer 12 and the second electrode layer 13 are sequentially patterned by using a publicly-known laser patterning method to form the multiple solar cells 10 and the extracting electrode 20.

Next, the extracting wire member 30 (solder-plated copper foil) is ultrasonically soldered to the extracting electrode 20. Subsequently, the output wire member 35 is soldered to the extracting wire member 30. Then, the insulating film 36 is inserted between the extracting wire member 30 and the solar cell 10.

Subsequently, the covering member 40 (adhesive tape) is bonded to the extracting electrode 20 so as to cover the extracting wire member 30. Thereafter, the bonding layer 50 and the protection member 60 are sequentially deposited thereon. In this event, an end of the output wire member 35 is drawn through a slit formed in the bonding layer 50 and the protection member 60.

Then, this deposited body is heated in vacuum by using a laminator device to complete the solar cell module 100. Incidentally, a frame made of Al, SUS or iron may be attached to the solar cell module 100.

### (Effects and Advantages)

The solar cell module 100 according to this embodiment includes: the extracting wire member 30 connected to the extracting electrode 20; the covering member 40 covering the extracting wire member 30; and the bonding layer 50 bonding these. The extracting wire member 30 is isolated from the bonding layer 50 by the covering member 40.

In this way, the extracting wire member 30 is isolated from the bonding layer 50, and thus is not in direct contact with the bonding layer 50. This makes it possible to reduce stress which the extracting wire member 30 undergoes from the bonding layer 50 depending on a temperature change in an environment in which the solar cell module 100 is used. Accordingly, the damage of a connection portion between the extracting electrode 20 and the extracting wire member 30 can be suppressed.

In this respect, the "connection portion" between the extracting electrode 20 and the extracting wire member 30 is not limited to an interface between the extracting electrode 20 and the extracting wire member 30. For example, in a case where the extracting wire member 30 is connected to the second electrode layer 13 deposited on the semiconductor layer 12, separation is particularly likely to occur at an interface between the semiconductor layer 12 and the second electrode layer 13. Even in such a case, the solar cell module 100 according to this embodiment can prevent the second electrode layer 13 from being separated from the semiconductor layer 12.

In the above-described manner, it is possible to suppress a decrease in output of the solar cell module 100 in its use environment.

### [Second Embodiment]

Next, a second embodiment of the present invention will be described. The point where this embodiment is different from the above-described first embodiment is the structure of the covering member 40. Other points are the same as the above-described first embodiment, and thus the different point will be mainly described below.

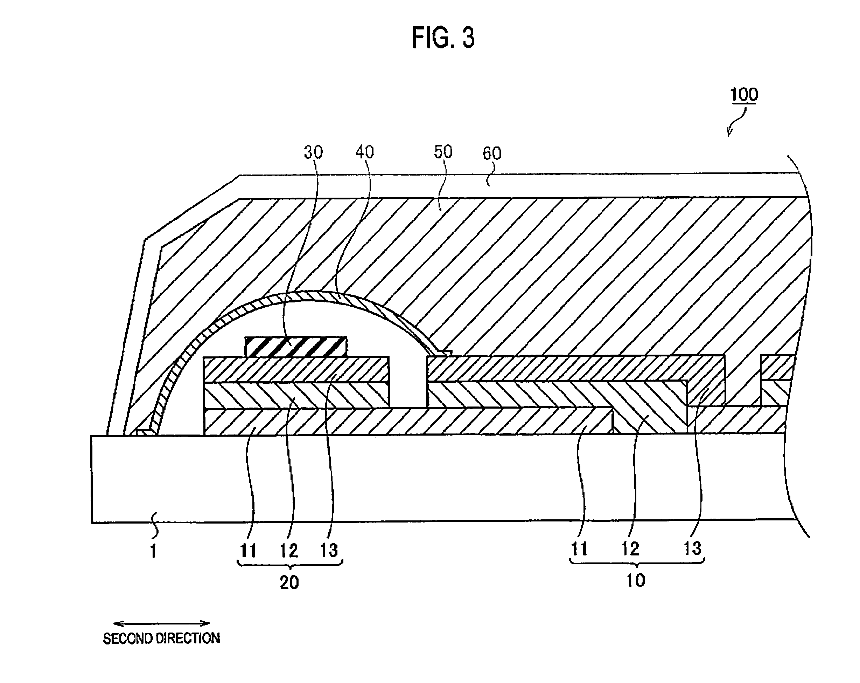

A covering member 40 according to this embodiment covers the extracting electrode 20 and the extracting wire member 30. Accordingly, as shown in Fig. 3, the extracting electrode 20 and the extracting wire member 30 are not in direct contact with the bonding layer 50. In this manner, the extracting electrode 20 and the extracting wire member 30 are isolated from the bonding layer 50 by the covering member 40.

Here, the covering member 40 according to this embodiment is a strip-shaped member. A flexible material such as a PET film, and a non-flexible material such as ceramics may be used for the covering member 40. As shown in Fig. 3, the covering member 40 does not necessarily have to be in contact with the extracting electrode 20 and the extracting wire member 30.

Two edge portions in the second direction of the covering member 40 are adhesive. One edge portion of the covering member 40 is bonded to the substrate 1 along the first direction. The other edge portion of the covering member 40 is bonded to the solar cell 10 adjacent to the extracting electrode 20 along the first direction.

### (Effects and Advantages)

In this embodiment, the extracting electrode 20 and the extracting wire member 30 are isolated from the bonding layer 50 by the covering member 40.

In this way, the extracting electrode 20 and the extracting wire member 30 are not in direct contact with the bonding layer 50. This makes it possible to reduce stress which the extracting electrode 20 and the extracting wire member 30 undergo from the bonding layer 50 depending on a temperature change in an environment in which the solar cell module 100 is used. Accordingly, it is possible to suppress the accumulation of damage not only on a connection portion between the extracting wire member 30 and the extracting electrode 20 but also on the extracting electrode 20 itself. As a result, a decrease in output of the solar cell module 100 in its use environment can be further suppressed.

### (Other Embodiments)

The present invention has been described by the above-described embodiments. However, it should not be understood that the description and drawings constituting a part of the disclosure intend to limit the present invention. Various alternative embodiments, examples, and operational techniques will be apparent for those skilled in the art from the disclosure.

For example, in the above-described embodiments, the semiconductor layer 12 is mainly composed of a silicon semiconductor material. However, the material is not limited to this, and other semiconductor materials may be employed instead. For example, a non-silicon semiconductor material such as a cadmium telluride semiconductor material, or a CIS (copper, indium, selenium) or CIGS (copper, indium, gallium, selenium) semiconductor material may be used.

In addition, in the above-described embodiments, the solar cell module 100 receives light on the substrate 1 side. Alternatively, the solar cell module 100 may receive light on the protection member 60 side. Specifically, when the solar cell module 100 receives light on the protection member 60 side, it is only necessary that the second electrode layer 13, the bonding layer 50 and the protection member 60 be transparent.

Moreover, in the above-described embodiments, the covering member 40 covers substantially the whole of the extracting wire member 30. However, the effect of the present invention can be achieved as long as the covering member 40 covers at least a part of the extracting wire member 30. For example, when the extracting electrode 20 and the extracting wire member 30 are connected to each other at multiple connection portions, it is only necessary that the covering member 40 cover a portion of the extracting wire member 30 other than the connection portions.

Further, in the above-described embodiments, the whole of or the two edge portions of the covering member 40 are adhesive. However, the covering member 40 does not necessarily have to be adhesive.

Furthermore, in the above-described embodiments, the extracting electrode 20 is formed at each of two end sides of the multiple solar cells 10. However, the location of the extracting electrode 20 is not limited to the two end sides of the multiple solar cells 10.

As described above, it goes without saying that the present invention includes various embodiments and the like not listed herein. Accordingly, the technical scope of the present invention is defined only by the features of the invention according to the scope of the invention as defined by the appended claims appropriate for the above description.

### Industrial Applicability

As has been described, the present invention can provide a solar cell module capable of reducing stress which a extracting wire member connected to a extracting electrode undergoes from a bonding layer, and thus is advantageous in the field of solar power generation.

## Claims

1. A solar cell module comprising:
a substrate having an insulation property;
a plurality of solar cells which are formed on the substrate;
an extracting electrode which is formed on the substrate and which is for extracting electric charges generated by the plurality of solar cells;
an extracting wire member which is connected to the extracting electrode and which is for collecting electric charges from the extracting electrode;
a covering member covering the extracting wire member; and
a bonding layer bonding the plurality of solar cells, the extracting electrode, the extracting wire member and the covering member between the bonding layer and the substrate, wherein
the extracting wire member is isolated from the bonding layer by the covering member.

2. The solar cell module according to claim 1, wherein the covering member is an adhesive tape which is adhesive on a surface on the extracting wire member side.

3. The solar cell module according to claim 1, wherein the covering member covers the extracting electrode, and the extracting electrode is isolated from the bonding layer by the covering member.

## Amended claims

### Amended claims under Art. 19.1 PCT

1. (Amended)
A solar cell module comprising:
a substrate having an insulation property;
a plurality of solar cells each of which is formed on the substrate in a first direction and which are arranged in a second direction crossing the first direction;
a extracting electrode which is formed on the substrate in the first direction and which is for extracting electric charges generated by the plurality of solar cells;
a extracting wire member which is connected to the extracting electrode and which is for collecting the electric charges from the extracting electrode;
a covering member which covers the extracting wire member; and
a bonding layer bonding the plurality of solar cells, the extracting electrode, the extracting wire member and the covering member between the bonding layer and the substrate, wherein
the extracting wire member is isolated from the bonding layer by the covering member, and
both edge portions of the covering member are disposed on two edge portions in the first direction of the extracting electrode.

2. The solar cell module according to claim 1, wherein the covering member is an adhesive tape which is adhesive on a surface on the extracting wire member side.

3. The solar cell module according to claim 1, wherein the covering member covers the extracting electrode, and
the extracting electrode is isolated from the bonding layer by the covering member.
